# FASCICULE DE BREVET EUROPEEN

(11) **EP 0 628 827 B1**
(45) Date de publication et mention de la délivrance du brevet: **02.08.1995**
(21) Numéro de dépôt: 94401170.9
(22) Date de dépôt: 26.05.1994
(51) Int. Cl.: G01R 19/165

(54) **Circuit intégré comportant un circuit de détection du niveau d'une tension de service**
Integrierte Schaltung mit einer Schaltung zur Pegeldetektion einer Betriebsspannung
IC device including a level detection circuit of an operating voltage

(30) Priorité: 11.06.1993 FR 9307095
(43) Date de publication de la demande: 14.12.1994
(73) Titulaire: SGS-THOMSON MICROELECTRONICS S.A., 94250 Gentilly (FR)
(72) Inventeur: Fournel, Richard, F-75116 Paris (FR); Lisart, Mathieu, F-75116 Paris (FR)
(74) Mandataire: Schmit, Christian Norbert Marie

(56) Documents cités:
- EP-A- 0 506 531
- US-A- 3 444 397
- US-A- 3 648 181
- US-A- 4 378 521

## Description

La présente invention a pour objet un circuit intégré comportant un circuit de détection du niveau d'une tension de service utilisable dans le domaine des circuits semi-conducteurs, notamment de type CMOS. Le but de l'invention est de détecter le franchissement par une tension de service à surveiller d'un ou de plusieurs seuils de tension prédéterminés.

On connaît les circuits de détection du franchissement, par une tension à surveiller, d'une tension de référence comportant dans leur principe des amplificateurs de type différentiel recevant d'une part une tension de référence et d'autre part la tension de service. Ces circuits nécessitent d'introduire la tension de référence, d'une manière externe, avec beaucoup de précision. Ces circuits présentent cependant l'avantage que la tension de référence peut être quelconque du moment qu'elle est fixée extérieurement. Un des problèmes à résoudre consiste donc à produire une tension de référence dont la valeur peut être réglée à la demande mais qui, une fois choisie, est la même pour tous les circuits fabriqués.

On constate dans le domaine de la fabrication des circuits intégrés des dispersions de caractéristiques du circuit dues au procédé de fabrication du circuit d'une part et aux conditions d'utilisation d'autre part. Les dispersions de fabrication reflètent les variations subies par le circuit au cours des différentes phases de sa fabrication. On sait que les nombreux paramètres qui interviennent dans cette fabrication, durée et densité des implantations ioniques, nature et qualité des opérations de masquage effectuées conduisent à une très grande sensibilité du produit fabriqué à ces paramètres de fabrication et, en définitive, à une grande variation des caractéristiques obtenues. En cours d'utilisation un circuit intégré est soumis à des contraintes, notamment de température et de tension d'alimentation, qui peuvent retentir d'une manière néfaste sur la détermination des seuils de référence choisis.

En pratique, un autre dispositif de détection de seuils de tension a été imaginé. Il consiste à utiliser la tension d'avalanche d'une diode, de préférence même une diode de type ZENER. On sait par exemple que pour une technologie actuelle, la tension de seuil de détection d'une diode ZENER fabriquée selon un procédé donné ne variera, en fonction de la température d'utilisation du circuit que, par exemple de 5,35 à 5,48 volts. Cette faible dispersion est tout à fait intéressante. La tension de référence ainsi obtenue présente cependant l'inconvénient, pour un procédé donné, de ne pouvoir être réglable à la demande, puisqu'elle est déterminée par ce procédé.

Il ressort de cette situation que les circuits qui délivrent des tensions de référence, servant notamment à comparer une tension de service à cette tension de référence, soit sont compliqués pour être stables, constants et réglables, soit ils sont simples pour être stables et constants mais non réglables.

L'invention a pour objet de remédier à ces inconvénients en proposant un dispositif simple, dont le principe de détection est celui de la comparaison d'une tension de service à une tension de référence connue par un phénomène d'avalanche dans une jonction semi-conductrice, et qui par ailleurs soit réglable. On utilisera de préférence l'invention pour vérifier que la gamme de tension de fonctionnement d'un circuit intégré est conforme à une gamme résultant d'une spécification et on utilisera le signal de détection du niveau de la tension de service par rapport à cette tension de référence pour autoriser ou interdire le fonctionnement du circuit intégré.

L'invention a donc pour objet un circuit intégré comportant un circuit de détection du niveau d'une tension de service muni d'une diode détectrice dont la cathode est connectée à la tension de service, dont l'anode est connectée à une charge constituant une sortie du circuit de détection, et dont la tension d'avalanche sert de tension de référence, caractérisé en ce qu'il comporte un circuit de polarisation, connecté à une électrode de polarisation de la diode, pour polariser une jonction semiconductrice de la diode à au moins une valeur de polarisation.

L'invention sera mieux comprise à la lecture de la description qui suit et à l'examen des figures qui l'accompagnent. Celles-ci ne sont données qu'à titre indicatif et nullement limitatif de l'invention. Les figures montrent:
- Figure 1: un circuit intégré de détection conforme à l'invention;
- Figure 2: la courbe caractéristique d'une jonction semi-conductrice, en particulier d'une jonction de type ZENER;
- Figure 3: une coupe transversale d'un substrat semi-conducteur dans lequel est réalisé une diode détectrice selon l'invention;
- Figure 4a à 4k: des diagrammes temporels de signaux intervenant dans le dispositif de l'invention.

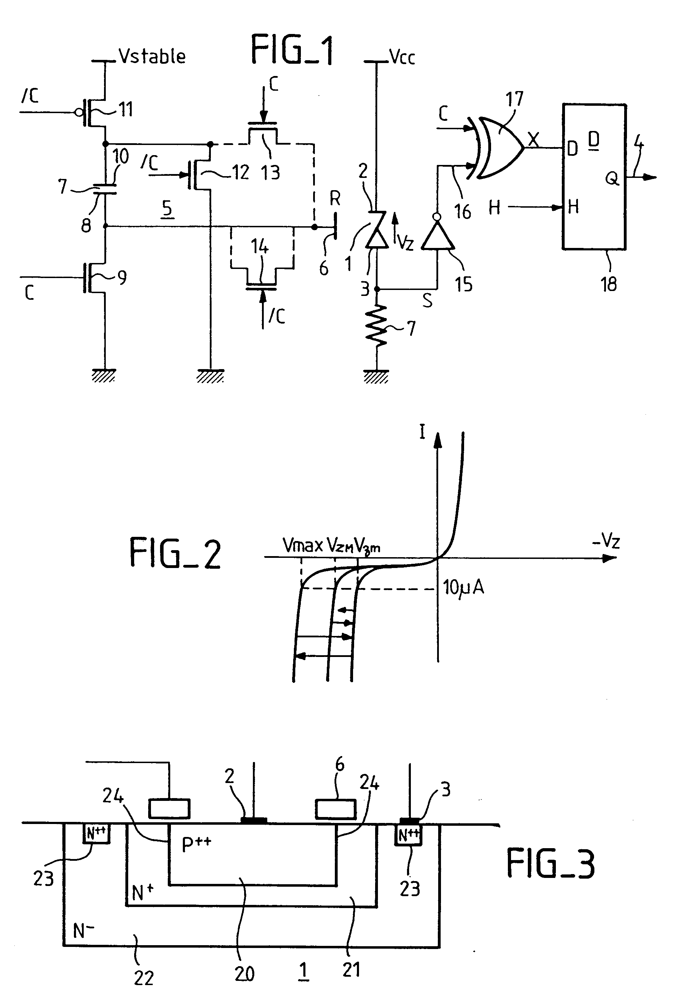

La Figure 1 montre un circuit intégré comportant un circuit de détection du niveau d'une tension de service selon l'invention. La tension de service à surveiller dans l'invention est par exemple une tension V_{cc} d'alimentation d'un circuit intégré et auquel le circuit de la Figure 1 est également raccordé. En pratique, le circuit de la Figure 1 est réalisé sur un même substrat semi-conducteur que le circuit intégré à surveiller. Ce circuit de détection comporte une diode détectrice 1, de préférence de type ZENER. La diode 1 possède une cathode 2 reliée, ici dans un exemple, directement à la tension de service Vcc. Elle possède également une anode 3 connectée à une sortie 4 du circuit de détection. Selon une variante préférée de l'invention, le circuit de détection comporte un circuit 5 délivrant un signal cyclique, de préférence alternatif, connecté à une électrode 6 de polarisation de la jonction de la diode. Le signal peut, d'une manière générale être constant. Sa valeur sert de réglage de seuil. Sous l'influence de cette tension cyclique, alternative dans le cas présent, la tension d'avalanche V_{z} de la diode 1 est modifiée. En conséquence un niveau de tension disponible à la sortie S dépend du niveau de la tension de service Vcc par rapport respectivement à une valeur haute V_{ZM} de la tension d'avalanche et à une valeur basse V_{bzm} de cette tension d'avalanche de la diode 1.

De préférence, l'anode 3 de la diode 1 est reliée à la masse par une résistance 7 qui peut être réalisée de différentes manières dans le circuit intégré, par exemple sous la forme d'un transistor de type N monté en résistance avec sa grille de commande connectée à son drain. De cette façon la diode 1 est polarisée en inverse.

Le principe de fonctionnement du dispositif est le suivant. Si la tension de service Vcc est supérieure à chacun des deux seuils V_{ZM}, et évidemment V_{zm}, la diode 1 est en permanence en avalanche et un signal S disponible à l'anode 3 de la diode 1 est à un niveau élevé: le courant passant dans la résistance 7 élève la tension d'anode 3. Ce niveau est élevé en permanence, quelle que soit l'alternance du signal alternatif appliqué sur l'électrode 6. A l'opposé, si la tension de service Vcc est plus faible que chacune des deux tensions d'avalanche de la diode 1, celle-ci est en permanence bloquée. Dans ce cas, le signal S est à niveau constant, mais égal à zéro cette fois. Par contre, si la tension de service est intermédiaire entre chacun des deux seuils V_{ZM} et V_{zm} la diode sera en avalanche pendant une alternance et bloquée pendant l'autre. En conséquence, le signal S disponible sur l'anode 3 sera également alternatif. On utilise cette caractéristique dans l'invention pour signaler que la tension de service est conforme à l'utilisation normale du circuit intégré.

Plutôt que d'avoir une polarisation avec seulement deux états appliqués sur la diode 1, il est possible d'avoir une polarisation avec plusieurs états, eux aussi appliqués séquentiellement et ou alternativement de manière à ce qu'un circuit logique puisse, en connaissance de l'état de polarisation appliqué, permettre de déterminer à quelle plage, parmi plusieurs plages de fonctionnement autorisé, appartient la tension de service surveillée. Autrement dit, le principe consiste à vérifier que, alors que la tension d'avalanche de la diode passe d'une valeur à une autre, le signal disponible à l'anode 3 de la diode 1 évolue ou n'évolue pas. S'il évolue, ceci signifie que la tension de service se situe dans la plage concernée, s'il n'évolue pas, ceci signifie qu'il se situe en dehors. On peut ainsi prévoir d'appliquer d'une manière périodique une succession de tensions calibrées de polarisation sur l'électrode 6 pour détecter entre ou en dehors de quelles valeurs calibrées se situe la tension de service Vcc.

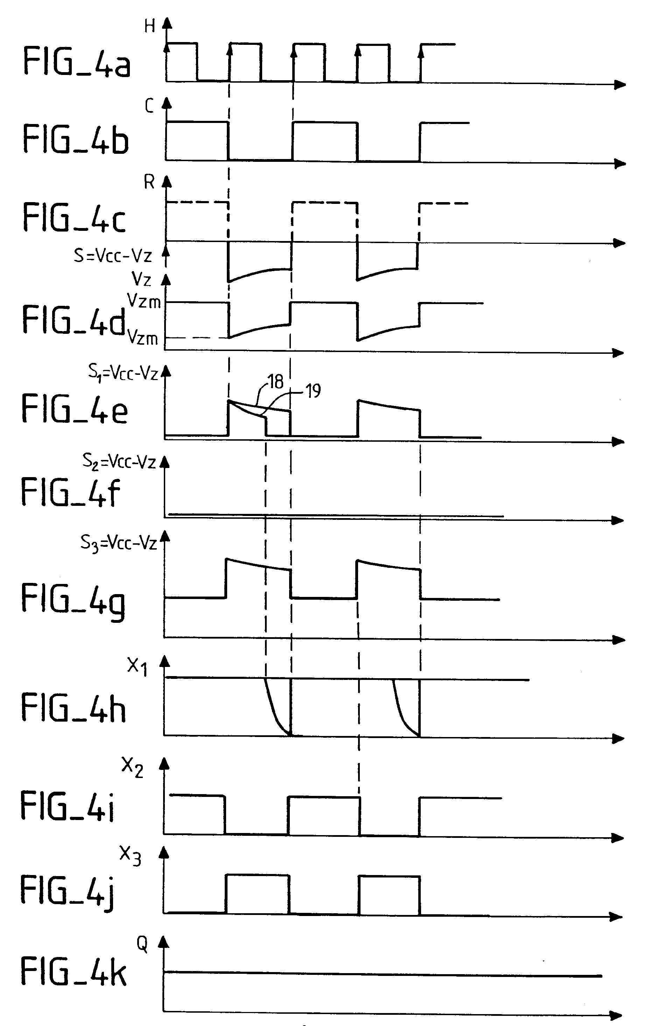

Pour produire les tensions de polarisation appliquées sur l'électrode 6, le circuit 5, dans un exemple préféré, comporte un condensateur 7 connecté par une première borne 8 d'une part à l'électrode 6 et d'autre part, par l'intermédiaire d'un transistor 9 à la masse. Le transistor 9 est, dans l'exemple représenté, un transistor de type N dont le drain est connecté à la borne 8 du condensateur 7 et dont la source est connectée à la masse. L'autre borne 10 du condensateur 7 est connectée par un transistor 11 de type P à une tension positive, de préférence stabilisée. Etant donné qu'on cherche à surveiller la tension de service V_{cc}, qui est en général la tension d'alimentation du circuit intégré, il peut ne pas paraître judicieux de connecter la source du transistor 11 à cette tension de service elle-même. Cependant, ceci est également possible: les tolérances de définition des tensions d'avalanche V_{ZM} et V_{zm} peuvent alors en être légèrement affectées. Le drain du transistor 11 relié à la borne 10 du condensateur 7 est lui-même relié au drain d'un transistor 12 de type N. La source du transistor 12 est reliée à la masse. Les transistors 9 et 11 reçoivent respectivement des signaux de commande C et /C, complémentaires l'un de l'autre, alternatifs, de préférence carrés. Ces signaux sont par ailleurs visibles sur la Figure 4b. Le transistor 12 reçoit aussi un signal /C, complémentaire du signal C.

Dans ces conditions le fonctionnement du circuit 5 est le suivant. Lorsque le signal C est à un niveau haut les transistors 11 et 9 sont passants et le transistor 12 est bloqué. Dans ces conditions, la borne 10 du condensateur 7 est chargée positivement: elle est portée à une tension égale à la tension stabilisée moins V_{z}. La borne 8, par contre, est portée à la masse. Lors de l'alternance suivante, de préférence les alternances sont non recouvrantes, la borne 10 est connectée à la masse par le transistor 12 alors que la borne 8 continue à être connectée à l'électrode 6. Dans ces conditions, l'électrode 6 reçoit une tension négative par rapport à la masse, dont la valeur est sensiblement égale à la valeur absolue de la tension stabilisée de polarisation. Soumises à l'influence de cette tension négative, le profil de la jonction est modifié. Dans ce cas la tension d'avalanche V_{z} varie. Cette variation est représentée d'une manière schématique sur la Figure 2 où on voit la courbe caractéristique de réponse d'une diode ZENER en courant et tension. A environ 10 microampères, cette valeur de tension d'avalanche varie, par exemple entre 5,5 volts et 3 volts.

La Figure 1 montre, d'une manière optionnelle en tirets, un transistor 13 de type N connecté par son drain à la source du transistor 11 et par sa source à l'électrode 6. De la même façon, un transistor 14 s'interpose dans la liaison entre la borne 8 du condensateur 7 et l'électrode 6. Quand le transistor 14 est interposé cette liaison passe obligatoirement par ce transistor. Le drain et la source du transistor 14 sont reliés respectivement à la borne 8 et à l'électrode 6. Dans un exemple, le transistor 13 reçoit le signal C tandis que le transistor 14 reçoit le signal /C sur sa grille de commande. Un tel montage impose que, au lieu de soumettre l'électrode 6 à une tension oscillant entre celle de la masse ou celle en négatif de la valeur de la tension stabilisée, on impose sur cette électrode 6 plus ou moins la tension de la valeur stabilisée.

De ce fait, Figure 2, on déplace vers des valeurs plus grandes la tension d'avalanche de la diode 1. Celle-ci oscille alors entre une valeur Vₘₐₓ et V_{zm}. On voit qu'en montant des transistors tels que les transistors 9 et 11 à 14 on peut imposer avec des commandes adéquates sur ces transistors une polarisation oscillant entre n'importe laquelle des trois valeurs de polarisation possibles: V stable, 0 volt, moins V stable. Il suffit par exemple, en commandant les transistors 13 et 14 respectivement par des signaux /C et C de modifier les deux polarisations alternatives.

On peut bien entendu imaginer, pour disposer d'autres valeurs de polarisation de prévoir à la place du condensateur 7 une cascade de condensateurs montés en série et la connexion de points milieux entre deux condensateurs consécutifs, optionnellement, à l'électrode 6 en commandant d'une manière adéquate un transistor de connexion. On peut alors soumettre cette électrode à une palette de tensions de polarisation. Selon l'invention cette palette sera réappliquée cycliquement, et en correspondance on exploitera en synchronisation le signal S qui en résulte.

On va expliquer maintenant comment est traité le signal S, de type théoriquement constant lorsque la tension de service a une valeur extérieure à la plage surveillée, ou de type alternatif lorsque cette tension de service a une valeur comprise dans la plage surveillée. Dans ce but, dans un exemple, on relie l'anode 3 de la diode 1 à un inverseur 15 dont le niveau d'équilibre est par exemple faible: par exemple de V_{cc}/5. Sur la Figure 2, la coupe caractéristique représentée est celle d'une diode de type ZENER de façon à ce que sa pente soit la plus raide possible lorsque, en négatif, la tension appliquée en inverse à la diode dépasse la tension d'avalanche. Dans ce cas, quel que soit le courant qui passe dans la résistance 7, la tension de l'anode 3 est portée à Vcc moins cette valeur de tension en avalanche qui est sensiblement constante. La valeur du seuil de détection de l'inverseur 15 a alors juste besoin d'être inférieure à cette tension. Les aléas de fabrication et de conditions d'utilisation à la fois en température et en tension d'alimentation de cet inverseur ont donc des effets négligeables. La sortie 16 de l'inverseur 15 est appliquée sur une première entrée d'une porte logique, ici de type OU Exclusif 17. La porte 17 reçoit sur son autre entrée le signal C.

La Figure 4c montre la valeur appliquée en polarisation sur l'électrode 6. Le signal R ainsi appliqué présente des créneaux négatifs et, en option, des créneaux positifs. Dans les créneaux négatifs on observe une légère décroissance en valeur absolue de la tension due à la décharge du condensateur 7 dans des fuites. Dans l'immédiat on néglige cet effet. On expliquera par la suite comment on peut s'en affranchir.

La Figure 4d montre en correspondance le diagramme temporel de la tension d'avalanche de la diode 1. Lorsque le signal C est au niveau haut, l'électrode 6 est portée à la masse d'une manière constante: la tension d'avalanche est égale à V_{ZM}. Par contre, lorsque la tension négative de la borne 10 est portée sur l'électrode 6 la tension d'avalanche est plus faible: elle vaut V_{zm}. La tension d'avalanche V_{zm} évolue par ailleurs conformément à la décroissance exponentielle due à la décharge du condensateur 7.

La Figure 4e montre l'allure d'un signal S₁ disponible sur la borne 3 lorsque la tension de service V_{cc} est intermédiaire entre les deux tensions d'avalanche de la diode 1. Lorsque le signal C est au niveau haut le signal S₁ est nul. Lorsque le signal C est au niveau bas le signal S₁ est au niveau haut. Sur la Figure 4e on a fait figurer, selon deux tracés 18 et 19, des effets différents selon que la décroissance due à la décharge du condensateur 7 est faible et négligeable ou importante. Lorsqu'elle est faible, le signal S₁ reste au niveau haut jusqu'à la fin de l'alternance. Lorsqu'elle est forte, le signal S₁ retombe au niveau bas avant la fin de l'alternance.

La Figure 4f montre la valeur d'un signal S2: le signal S lorsque V_{cc} est inférieur à la tension de seuil bas: V_{zm}. Dans ce cas, la diode 1 est toujours bloquée. Le signal S₂ est nul tout le temps.

La figure 4g montre dans les mêmes conditions ce qui se passe pour un signal S₃,: le signal S lorsque V_{cc} est supérieur au seuil haut VZM. Dans ce cas la diode 1 est en avalanche dans tous les cas. La résistance 7 est donc chargée en permanence par un courant. Ce courant est par ailleurs légèrement plus fort lorsque le signal C est à l'état bas. Dans tous les cas le signal S₃ est en permanence supérieur à la tension de seuil de déclenchement de l'inverseur 15. Il résulte de cette situation que la sortie 16 de l'inverseur 15 est constante lorsque la tension de service est extérieure à la gamme surveillée, et alternative lorsqu'elle est comprise dans cette gamme.

Avec la porte OU exclusif 17 recevant le signal C on inverse cette allure et on transforme le signal S alternatif en un signal X constant, ou le signal S constant en un signal X alternatif respectivement. Il apparaît ainsi qu'un signal X₁, correspondant au signal S₁ est constant, au moins si la décharge du condensateur 7 est faible. Par contre, des signaux X₂ et X₃ correspondants respectivement aux sorties S₂ et S₃ sont alternatifs. On exploite le caractère alternatif de ces sorties pour juger de la valeur de la tension de service. On notera par ailleurs que, si la tension de service est inférieure au seuil bas (S2, X2) le signal X est en phase avec le signal C. Si par contre elle est supérieure à la tension d'avalanche supérieure, le signal X est en opposition de phase avec le signal C. En conséquence, le circuit logique 17 permet de bien juger de la valeur de la tension de service.

Pour éviter les effets de la décharge du condensateur 7 on interpose en sortie du circuit de l'invention une bascule de type D 18. Cette bascule de type D comporte deux entrées une entrée D et une entrée H et une sortie: une sortie Q. Le principe d'une bascule de type D est de transmettre, et de maintenir, à sa sortie Q une valeur d'un signal introduit en D au moment où l'entrée H reçoit un front, par exemple un front de montée, d'un signal binaire.

Dans ce but, Figure 4a, on utilise un signal d'horloge H possédant des fronts de montée à l'instant des transitions montantes et descendantes du signal C. En pratique, on pourra produire le signal C avec un circuit bistable recevant un signal d'horloge sur son entrée de commande.

Dans ces conditions, au moment où le front de montée du signal H se présente, le signal X₁ est toujours à un état haut. Il ne chute à un état bas qu'à la fin de l'impulsion. Dans ces conditions, un signal Q, Figure 4k, est maintenu à un état haut lorsque la tension de service est comprise dans la plage V_{ZM} - V_{zm}. Bien entendu, le signal Q évolue alternativement dans le cas contraire.

Une autre façon de remédier au problème de la décharge du condensateur 7 pourrait consister à augmenter la fréquence du signal d'horloge H et en correspondance du signal de commande C. On est cependant limité dans ce mode par la mise en fonctionnement dynamique de la diode ZENER du fait d'accumulation de charges dans la zone de diffusion de la jonction de cette diode. En pratique, un fonctionnement à 1 Kilohertz est tout à fait supporté et amène de bons résultats.

La Figure 3 montre un exemple préféré de réalisation d'une diode de type ZENER utilisable comme diode 1. Cette diode comporte une première zone 20 circulaire peu profonde de type P++ implantée avec des impuretés de Bore avec une densité de l'ordre de 10²⁰. La zone 20 est implantée dans une zone 21 de type N+ qui l'entoure et servant à réaliser des condensateurs de type dit: "Capa implant". Cette zone 21 est implantée normalement avant mise en oeuvre du polysilicium de premier niveau. La densité des impuretés de phosphore ou d'arsenic qui est implantée est de l'ordre de 10¹⁸. La zone 21 elle-même est implantée dans une zone N- 22 dont la densité d'implantation, avec des mêmes types d'impuretés, est de l'ordre de 5.10¹⁶. Les zones 20, 21 et 22 constituent de préférence une construction concentrique vue du dessus. Dans l'anneau de la zone 22, on réalise en outre un anneau 23 dopé N++ avec un dopage de l'ordre de 10²⁰ impuretés d'arsenic. La diode de la Figure 3 est une diode ZENER parce que les zones 20 et 21 formant entre elles la jonction sont fortement dopées. Au-dessus de la jonction, à une frontière 24 entre les zones 20 et 21, on réalise une électrode 6 en polysilicium.

L'électrode 6 est par exemple séparée de la zone de jonction 24 par un oxyde de grille, réalisable en même temps que des oxydes de grille des transistors 11 à 14.

L'électrode 6 a également une forme circulaire (sur la Figure 3 on voit une coupe diamétrale). La zone 20 sert de cathode alors que l'anneau 23 sert d'anode. Chacune de ces deux zones 20 et 23 est reliée par une métallisation, par exemple d'aluminium, au plot concerné du circuit.

## Revendications

1. Circuit intégré comportant un circuit de détection du niveau d'une tension de service muni d'une diode détectrice (1) dont la cathode (2) est connectée à la tension de service, dont l'anode (3) est connectée à une sortie (4) du circuit de détection, et dont la tension d'avalanche sert de tension de référence, caractérisé en ce qu'il comporte un circuit de polarisation (5), connecté à une électrode de polarisation (6) de la diode (1), pour polariser une jonction semiconductrice de la diode (1) à au moins une valeur de polarisation.

2. Circuit intégré selon la revendication 1, caractérisé en ce que le circuit de polarisation (5) comporte un circuit délivrant un signal cyclique pour polariser cycliquement la diode (1) à différentes valeurs de polarisation.

3. Circuit intégré selon la revendication 1, ou la revendication 2, caractérisé en ce que la diode est une diode ZENER (1).

4. Circuit intégré selon l'une des revendications 1 à 3, caractérisé en ce que le circuit pour polariser comporte un condensateur (7) connecté, par une première borne (8), d'une part à l'électrode de polarisation (5) de la diode (1) et d'autre part à une masse du circuit intégré par un premier transistor (9) et, par une deuxième borne (10), à une tension positive stabilisée du circuit intégré par un deuxième transistor (11), et en ce qu'un circuit délivrant un signal cyclique délivre un signal alternatif, de préférence carré.

5. Circuit intégré selon l'une des revendications 1 à 3, caractérisé en ce que le circuit pour polariser comporte un jeu de condensateurs connectés par un circuit logique, en correspondance avec un signal cyclique, à l'électrode de polarisation (6) de la diode (1), à une masse du circuit intégré, et à une tension positive stabilisée du circuit intégré.

6. Circuit intégré selon l'une des revendications 1 à 5, caractérisé en ce qu'il comporte un circuit de sortie muni d'une porte logique (17) connectée à l'anode (3) de la diode (1) et à un circuit délivrant un signal de synchronisation du signal cyclique.

7. Circuit intégré selon la revendication 6, caractérisé en ce que la porte logique est une porte OU Exclusif (17).

8. Circuit intégré selon l'une des revendications 1 à 7, caractérisé en ce qu'il comporte un circuit de sortie (18) pour détecter un niveau de sortie au début de chaque alternance d'un signal cyclique alternatif.

9. Circuit intégré selon la revendication 7, caractérisé en ce que le circuit de sortie comporte une bascule D (18) déclenchée par un signal de synchronisation de l'alternance d'un signal cyclique alternatif.

## Patentansprüche

1. Integrierte Schaltung mit einer Erfassungsschaltung zur Erfassung des Pegels einer Betriebsspannung, die eine Erfassungsdiode (1) umfaßt, deren Kathode (2) mit der Betriebsspannung verbunden ist, deren Anode (3) mit dem Ausgang (4) der Erfassungsschaltung verbunden ist, und deren Avalanchespannung als Bezugsspannung dient,
dadurch **gekennzeichnet**, daß
sie eine Vorspannungsschaltung (5) umfaßt, die mit einer vorspannelektrode (6) der Diode (1) verbunden ist, um einen Halbleiterübergang der Diode (1) auf wenigstens einen Vorspannungswert vorzuspannen.

2. Integrierte Schaltung nach Anspruch 1,
dadurch gekennzeichnet, daß
die Vorspannungsschaltung (5) eine Schaltung umfaßt, die ein zyklisches Signal liefert, um die Diode (1) zyklisch auf unterschiedliche Vorspannungswerte vorzuspannen.

3. Integrierte Schaltung nach Anspruch 1 oder 2,
dadurch gekennzeichnet, daß
die Diode eine Zenerdiode (1) ist.

4. Integrierte Schaltung nach einem der Ansprüche 1 bis 3,
dadurch gekennzeichnet, daß
die Vorspannungsschaltung einen Kondensator (7) umfaßt, der über einen ersten Anschluß (2) zum einen mit der Vorspannelektrode (5) der Diode (1) und andererseits mit einer Masse der integrierten Schaltung über einen ersten Transistor (9) und über einen zweiten Anschluß (10) mit einer stabilisierten positiven Spannung der integrierten Schaltung über einen zweiten Transistor (11) verbunden ist, und daß eine ein zyklisches Signal liefernde Schaltung ein alternierendes Signal, vorzugsweise ein Rechtecksignal liefert.

5. Integrierte Schaltung nach einem der Ansprüche 1 bis 3,
dadurch gekennzeichnet, daß
die Vorspannschaltung einen Satz von Kondensatoren (13, 14) umfaßt, die über eine logische Schaltung entsprechend einem zyklischen Signal mit der Vorspannelektrode (6) der Diode (1), einer Masse der integrierten Schaltung bzw. einer stabilisierten positiven Spannung der integrierten Schaltung verbunden werden.

6. Integrierte Schaltung nach einem der Ansprüche 1 bis 5,
dadurch gekennzeichnet, daß
sie eine Ausgangsschaltung mit einem logischen Gatter (17) umfaßt, das mit der Anode (3) der Diode (1) und einer Schaltung verbunden ist, die ein Signal zum Synchronisieren des zyklischen Signals abgibt.

7. Integrierte Schaltung nach Anspruch 6,
dadurch gekennzeichnet, daß
das logische Gatter ein exklusiv-Oder-Gatter (17) ist.

8. Integrierte Schaltung nach einem der Ansprüche 1 bis 7,
dadurch gekennzeichnet, daß
sie eine Ausgangsschaltung (18) zum Erfassen eines Ausgangspegels zu Beginn eines jeden Vorzeichenwechsels eines alternierenden zyklischen Signals umfaßt.

9. Integrierte Schaltung nach Anspruch 7,
dadurch gekennzeichnet, daß
die Ausgangsschaltung ein D-Flip-Flop (18) umfaßt, das von einem Signal zum Synchronisieren des Vorzeichenwechsels eines alternierenden zyklischen Signals ausgelöst wird.

## Claims

1. Integrated circuit including a circuit for detecting the level of an operating voltage, provided with a detector diode (1) whose cathode (2) is connected to the operating voltage, whose anode (3) is connected to an output (4) of the detector circuit, and whose avalanche voltage serves as a reference voltage, characterised in that it includes a biasing circuit (5), connected to an electrode (6) for biasing the diode (1), so as to bias a semiconductor junction of the diode (1) at at least one biasing value.

2. Integrated circuit according to Claim 1, characterised in that the biasing circuit (5) includes a circuit delivering a cyclic signal for cyclically biasing the diode (1) at different biasing values.

3. Integrated circuit according to Claim 1 or Claim 2, characterised in that the diode is a Zener diode (1).

4. Integrated circuit according to one of Claims 1 to 3, characterised in that the biasing circuit includes a capacitor (7) connected, by a first terminal (8), on the one hand to the electrode (5) for biasing the diode (1), and on the other hand to an earth of the integrated circuit through a first transistor (9), and, by a second terminal (10), to a stabilised positive voltage of the integrated circuit through a second transistor (11), and in that a circuit delivering a cyclic signal delivers an alternating signal, preferably square.

5. Integrated circuit according to one of Claims 1 to 3, characterised in that the biasing circuit includes a set of capacitors connected by a logic circuit, in accordance with a cyclic signal, to an electrode (6) for biasing the diode (1), to an earth of the integrated circuit, and to a stabilised positive voltage of the integrated circuit.

6. Integrated circuit according to one of Claims 1 to 5, characterised in that it includes an output circuit provided with a logic gate (17) connected to the anode (3) of the diode (1) and to a circuit delivering a signal synchronising the cyclic signal.

7. Integrated circuit according to Claim 6, characterised in that the logic gate is an Exclusive OR gate (17).

8. Integrated circuit according to one of Claims 1 to 7, characterised in that it includes an output circuit (18) for detecting an output level at the start of each half-cycle of an alternating cyclic signal.

9. Integrated circuit according to Claim 7, characterised in that the output circuit includes a D flip-flop (12) triggered by a signal for synchronising the half-cycle of an alternating cyclic signal.
